(19) Europäisches Patentamt / European Patent Office / Office européen des brevets

(11) **EP 2 154 735 A1**

(12) **EUROPEAN PATENT APPLICATION**
published in accordance with Art. 153(4) EPC

(43) Date of publication:
**17.02.2010 Bulletin 2010/07**

(51) Int Cl.:
*H01L 35/34* (2006.01)  *B22F 9/24* (2006.01)
*C22C 1/05* (2006.01)  *H01L 35/16* (2006.01)
*H01L 35/18* (2006.01)  *B22F 3/14* (2006.01)

(21) Application number: **08765134.5**

(22) Date of filing: **29.05.2008**

(86) International application number:
**PCT/JP2008/060321**

(87) International publication number:
**WO 2008/149911 (11.12.2008 Gazette 2008/50)**

(84) Designated Contracting States:
**AT BE BG CH CY CZ DE DK EE ES FI FR GB GR
HR HU IE IS IT LI LT LU LV MC MT NL NO PL PT
RO SE SI SK TR**
Designated Extension States:
**AL BA MK RS**

(30) Priority: **06.06.2007 JP 2007150585**

(71) Applicant: **Toyota Jidosha Kabushiki Kaisha
Toyota-shi, Aichi-ken 471-8571 (JP)**

(72) Inventor: **MURAI, Junya
Toyota-shi
Aichi 471-8571 (JP)**

(74) Representative: **Duckworth, Timothy John
J.A. Kemp & Co.
14 South Square
Gray's Inn
London WC1R 5JJ (GB)**

(54) **METHOD FOR MANUFACTURING THERMOELECTRIC CONVERTER**

(57) A method of manufacturing a thermoelectric converter is provided, wherein an alcohol dispersion liquid comprising a ceramic particle having the average size of 1 to 100 nm and a salt of an element constituting the thermoelectric conversion material is prepared, and thereafter the dispersion liquid is dropped into a solution containing a reducing agent to deposit a raw material particle of the thermoelectric conversion material, which is subsequently subject to heating and sintering.

Fig. 1

**Description**

FIELD OF THE INVENTION

The present invention relates to a thermoelectric converter comprising ceramics as insulating materials.

BACKGROUND ART

A thermoelectric conversion material is a material which can interconvert thermal and electric energies, and constitutes a thermoelectric converter which is used as a thermoelectric cooling element or a thermoelectric power generating element. Thermoelectric conversion material is used for thermoelectric conversion using the Seebeck effect. Thermoelectric converting performance is represented by Formula (1) which is called the performance index ZT.

$$ZT = \alpha^2 \sigma T / \kappa \qquad (1)$$

(wherein, $\alpha$ represents the Seebeck coefficient, $\sigma$ represents the electrical conductivity, $\kappa$ represents the thermal conductivity, and T represents the measured temperature.)

It is apparent, according to Formula (1), that in order to improve the thermoelectric converting performances of a thermoelectric conversion material, Seebeck coefficient $\alpha$ and electrical conductivity $\sigma$ of the material are increased, and thermal conductivity $\kappa$ of the material is decreased. Sometimes, fine particles, which do not react with the base material of the thermoelectric conversion material, are added to the starting material particles of the thermoelectric conversion material to decrease thermal conductivity $\kappa$ of the material. Thereby, the inactive fine particles can scatter phonons, which are the major factor of the thermal conduction in a thermoelectric conversion material, to decrease thermal conductivity $\kappa$.

However, in a conventional conversion material in which the inactive fine particles are unevenly distributed, the inactive fine particles, which provide the scattering effect of the phonon, have a large adverse influence on the other physical properties, such as electrical resistivity, due to the uneven distribution thereof, thus an increase in the performance of the thermoelectric conversion materials is inhibited. In order to solve the problem, Japanese unexamined patent publication No. 2000-261047 and Japanese unexamined patent publication No. 3-148879 disclose, for example, a sintered thermoelectric conversion material, wherein fine particles, such as ceramic particles which do not react with the base material are evenly dispersed in the starting material comprising fine particles.

According to the known technology above, the microparticulation of the starting material in addition to the inactive fine particles to be dispersed makes it possible for the inactive fine particles to be easily dispersed in the entirety of the base material, thus leading to a high probability of the presence of the inactive fine particles between the starting material particles, whereby no crystallization of the starting material particles occurs. Additionally, the above prior art references describe that, by preparing the starting material and the inactive fine particles, so that they have substantially the same particle size, that is to say the diameter ratio is approximately equal to one, the inactive fine particles are evenly distributed in the thermoelectric conversion material, and thus, the degradation of other physical properties, such as the electrical resistivity, due to the uneven distribution of the inactive fine particles, can be suppressed.

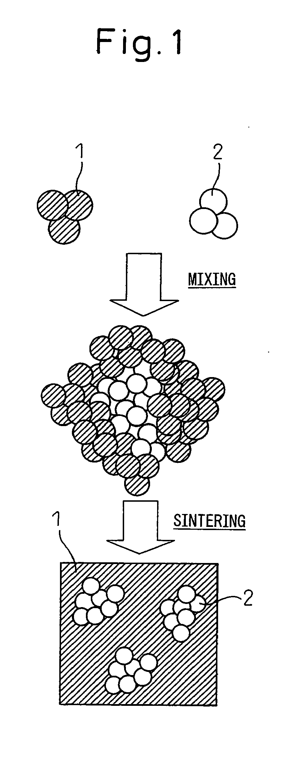

But, as the particles having a nanoscale diameter have a large specific surface area and tend to aggregate by Van der Waals' forces, etc. Consequently, the simple mixing of thermoelectric conversion material particles and inactive fine particles causes the inactive fine particles 2 to aggregate into a microscale aggregate, as shown in FIG. 1, and the inactive fine particles 2 cannot be dispersed in the thermoelectric conversion material 1 at the nanoscale. As a result, the distance between the inactive materials becomes larger than the mean free path of the phonons, and thermal conductivity cannot be sufficiently reduced.

In the known arts shown above, the inactive fine particles are evenly dispersed to adjust other physical properties, which do not directly relate to the equation (1), such as the electrical resistivity, but electrical conductivity $\sigma$ and thermal conductivity $\kappa$, both directly relating to the performance index ZT in the equation (1), have not been studied. Therefore, the inactive fine particles in the known arts above have a microscale diameter. The dispersion state of the inactive fine particles has not been precisely studied.

Since the carrier (an electron or electron hole) can carry both heat and electricity, electrical conductivity $\sigma$ and thermal conductivity $\kappa$ are proportional. Additionally, it is known that electrical conductivity $\sigma$ and Seebeck coefficient $\alpha$ are inversely proportional. Therefore, if electrical conductivity $\sigma$ is increased, thermal conductivity $\kappa$ is increased and Seebeck coefficient $\alpha$ is decreased accordingly. Furthermore, as the effective mass and mobility are inversely proportional, the effective mass is decreased when the mobility is increased.

Therefore, the object of the present invention is to eliminate the drawbacks of the prior art stated above by providing a method for manufacturing a thermoelectric converter having a good performance index.

DISCLOSURE OF THE INVENTION

In order to achieve the object shown above, the present invention provides a method for manufacturing a thermoelectric element for thermoelectric generation, comprising the steps of:

preparing an alcohol dispersion liquid comprising a ceramic particle having the average diameter of 1 to 100 nm, and a salt of an element constituting a thermoelectric conversion material; and

dropping the dispersion liquid into a solution containing a reducing agent to deposit a raw material particle of the thermoelectric conversion material, which is then subject to heating and sintering.

According to the present invention, thermoelectric conversion material particles are formed by depositing and heating the raw material particles of the thermoelectric conversion material in the dispersion liquid containing ceramic particles having an average diameter of 1 to 100 nm, followed by heat treatment, so that composite particles in which the ceramic particles and the thermoelectric conversion material particles are evenly dispersed without being aggregated can be obtained. Thus, a thermoelectric converter, wherein ceramic particles having an average diameter of 1 to 100 nm are evenly dispersed in the thermoelectric conversion material, is obtained by sintering the composite particles.

BRIEF DESCRIPTION OF THE DRAWINGS

FIG. 1 is a schematic diagram representing the manufacturing process of a thermoelectric conversion material, according to a known method.

FIG. 2 is a graph representing the relationship of the structure size of a thermoelectric conversion material to Seebeck coefficient $\alpha$, electrical conductivity $\sigma$, or thermal conductivity $\kappa$.

FIG. 3 shows a TEM image of an aggregate of $CoSb_2$ particles and $Al_2O_3$ particles.

FIG. 4 shows a TEM image of a thermoelectric converter of the present invention.

DESCRIPTION OF THE PREFERRED EMBODIMENT

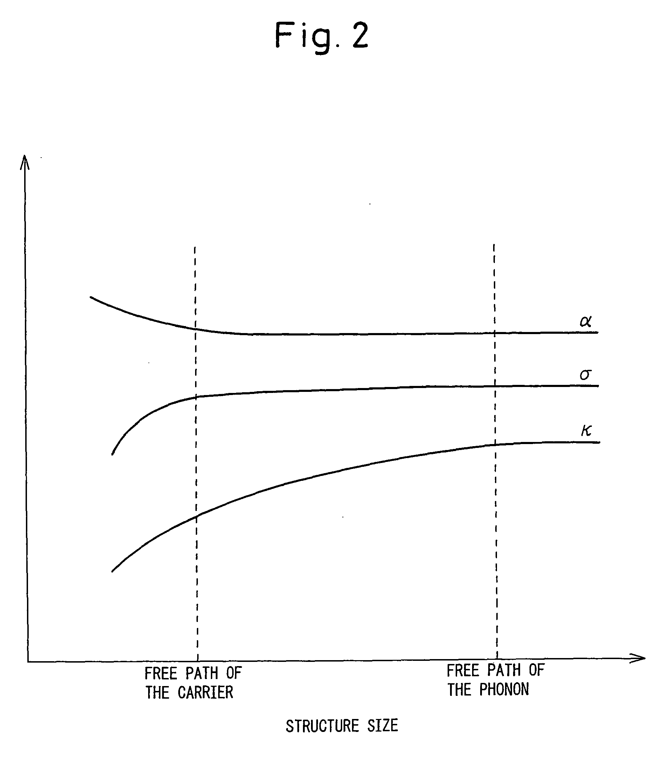

At first, the relationship between the performance index ZT and the structure constitution of the thermoelectric conversion material is explained in detail referring to FIG. 2. As shown in FIG. 2, thermal conductivity $\kappa$ of the thermoelectric conversion material is gradually decreased as the structure size of the thermoelectric conversion material becomes smaller than the length of the mean free path of the phonons. Therefore, performance index ZT is improved when the structure size is designed to be less than the mean free path of the phonons.

On the other hand, if the structure size of the thermoelectric conversion material becomes smaller than the mean free path of the phonons, electrical conductivity $\sigma$ does not decrease, but when the structure size becomes a particle size approximately equal to the length of the mean free path of the carrier or less, electrical conductivity $\sigma$ decreases. Based on the fact that the structure size of the thermoelectric conversion material at which thermal conductivity $\kappa$ begins decreasing is different from the structure size of the thermoelectric conversion material at which electrical conductivity $\sigma$ begins decreasing, performance index ZT represented by the formula (1) above can be further increased by selecting the structure size of the thermoelectric conversion material to be larger than the mean free path of a carrier and smaller than the mean free path of the phonons, so that the decreasing rate of thermal conductivity $\kappa$ is higher than the decreasing rate of the electrical conductivity.

What determines the structure size of the thermoelectric conversion material is the diameter of the ceramic particles, i.e., an insulating material dispersed in the thermoelectric conversion material, or the dispersion distance between the ceramic particles. Therefore, in the present invention, the dispersion distance between the ceramic particles is controlled so as to obtain the effect mentioned above.

That is, in the thermoelectric converter obtained by the method of the present invention, the distance between the ceramic particles dispersed in the thermoelectric conversion material is less than or equal to the length of the mean free path of the phonons of the thermoelectric conversion material.

The mean free path(MFP) is calculated by the formula below.

$$\text{Carrier MFP} = (\text{"mobility"} \times \text{"effective mass"} \times \text{"carrier velocity"}) / \text{"elementary electric charge"}$$

$$\text{Phonon MFP} = 3 \times \text{"lattice thermal conductivity"} / \text{"specific heat"} / \text{"acoustic velocity"}$$

In the formulae above, each value is obtained from the reference values and the approximation formula for the thermal properties, except that the measured value is used only for the specific heat.

The results of the carrier MFP and the phonon MFP calculated for $Co_{0.94}Ni_{0.06}Sb_3$ and $CoSb_3$ are shown below.

Table 1

| Calculated result of the carrier MFP and the phonon MFP (mean free path) | | | |
|---|---|---|---|
| Material | Temperature | Carrier MFP (nm) | Phonon MFP (nm) |
| $Co_{0.94}Ni_{0.06}Sb_3$ $Sb_3$ | 300K | 4.8 | 33 |
| | 673K | 5.1 | 15 |
| $CoSb_3$ $CoSb_3$ | 300K | 0.8 | 85 |
| | 673K | 1 | 42 |

As can be seen above, the carrier MFP and the phonon MFP are determined by the material and the temperature. In the thermoelectric converter obtained by the present invention, it is necessary that the structure size of at least a part of the thermoelectric converter is smaller than the mean free path of the phonons at the maximum output level of the power factor ($\alpha^2\sigma$) of the thermoelectric conversion material. As the $CoSb_3$ type material exhibits the maximum output of the power factor ($\alpha^2\sigma$) at 400°C, it is necessary that the size be smaller than the mean free path of the phonons at 400°C. Specifically, the distance is preferably in the range of 1 nm to 100 nm, and more preferably 10 nm to 100 nm.

In the present invention, at first, an alcohol dispersion liquid containing ceramic particles having the average diameter of 1 to 100 nm and a salt of an element constituting a thermoelectric conversion material is prepared.

As a ceramic, a commonly used material, such as alumina, zirconia, titania, magnesia, and silica, can be used. Among them, silica, zirconia, and titania are preferable because of their low thermal conductivity. One or more kinds of ceramic particles may be used. The specific resistance of the ceramics is preferably more than 1000 $\mu\Omega$m, and more preferably $10^6$ $\mu\Omega$m or more, and most preferably $10^{10}$ $\mu\Omega$m or more. The specific resistance not more than 1000 $\mu\Omega$m may interfere with the increase of ZT due to the high thermal conduction.

The average diameter of ceramic particles is equal to or less than the mean free path of the phonons, and is, specifically, 1 to 100 nm. Using a particle having such a diameter reduces thermal conductivity $\kappa$ of thermoelectric conversion material, thus leading to the improvement of the performance index ZT, because the distance between the ceramic particles dispersed in the formed thermoelectric converter becomes smaller than the mean free path of the phonons of the ceramics, causing the phonons to be considerably scattered in the thermoelectric conversion material.

The thermoelectric conversion material may be of a P-type or a N-type. The material for P-type thermoelectric conversion material is not specifically limited. For example, $Bi_2Te_3$ type material, PbTe type material, $Zn_4Sb_3$ type material, $CoSb_3$ type material, half Heusler type material, full Heusler type material, SiGe type material, etc., can be used. Likewise, the material for N-type thermoelectric conversion material is not specifically limited, and known material, such as $Bi_2Te_3$ type material, PbTe type material, $Zn_4Sb_3$ type material, $CoSb_3$ type material, half Heusler type material, full Heusler type material, SiGe type material, $Mg_2Si$ type material, $Mg_2Sn$ type material, or CoSi type material, can be used.

The thermoelectric conversion material used in the present invention preferably has an output factor of not less than 1 mW/K$^2$, and more preferably, not less than 2 mW/K$^2$, and most preferably, not less than 3 mW/K$^2$. If the output factor is smaller than 1 mW/K$^2$, a dramatic improvement of the performance can not be expected. Thermal conductivity $\kappa$ of the thermoelectric conversion material is preferably more than 5 W/mK, more preferably more than 7 W/mK, and most preferably is more than 10 W/mK. Particularly, if the thermal conductivity $\kappa$ is more than 5 W/mK, the effect of the present invention is remarkable. Namely, when the structure size of the thermoelectric conversion material is controlled at the nanoscale as specified in the present invention, there is a tendency that the use of the thermoelectric conversion material having a higher thermal conductivity $\kappa$ brings about a greater reduction of thermal conductivity $\kappa$, and particularly, when the thermoelectric conversion material having thermal conductivity $\kappa$ of more than 5 W/mK is used, the reducing effect of thermal conductivity $\kappa$ is enhanced.

The salts of the element constituting the thermoelectric conversion material mean, for example, cobalt chloride hydrate and antimony chloride in the case the thermoelectric conversion material is $CoSb_3$, and mean cobalt chloride hydrate, nickel chloride, and antimony chloride in the case the thermoelectric conversion material is $Co_{1-x}Ni_xSb_3$.

The mixing ratio of the ceramic particles to the thermoelectric conversion material particles is preferably 5 to 40 vol. % in the thermoelectric converter obtained by the method of the present invention. The alcohol, which is a solvent of the dispersion liquid, is not specifically limited, as long as it can disperse a salt of an element constituting the thermoelectric conversion material described above and ceramic particles, but ethanol can be preferably used. A pH controlling agent may be added when needed. As the pH controlling agent, which is used to prevent the aggregation of the particles, etc., in a slurry, known agents such as hydrochloric acid, acetic acid, nitric acid, ammonia water, sodium hydrate, and sodium borohydride($NaBH_4$) can be used.

The pH of the dispersion liquid is preferably 3 to 6 or 8 to 11, and more preferably 4 to 6 or 8 to 10.

After the dispersion liquid is prepared, the dispersion liquid is dropped into a solution containing a reducing agent. The reducing agent can be of any type which can reduce an ion of an element constituting the thermoelectric conversion material, such as $NaBH_4$ or hydrazine.

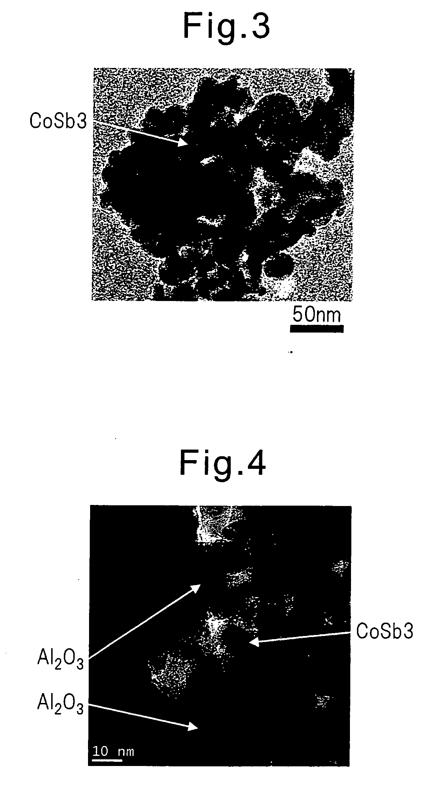

There is an ion of the raw material of the thermoelectric conversion material, such as Co ion or Sb ion, in the dispersion liquid containing a salt of an element constituting the thermoelectric conversion material. Therefore, as shown in FIG. 3a, these ions are reduced when mixed with a solution containing a reducing agent, depositing particles of the element constituting the thermoelectric conversion material, such as Co particles or Sb particles. In the reduction, in addition to Co particles or Sb particles, side products, for example, NaCl and $NaBO_3$, are produced. In order to remove the side products, filtration is preferably performed. Additionally, it is preferable that the side products are washed by adding alcohol or water after filtration.

As described above, when particles of an element constituting the thermoelectric conversion material are deposited, ceramic particles having a diameter of 1 to 100 nm and particles of an element constituting the thermoelectric conversion material are evenly distributed in the dispersion liquid, because ceramic particles having the diameter of 1 to 100 nm are present in the dispersion liquid.

The dispersion liquid is subject to a heat treatment, preferably a hydro-thermal treatment, to form a thermoelectric conversion material from the elements constituting the same. The material is then dried to obtain an aggregate wherein the ceramic particles and the thermoelectric conversion material particles are evenly mixed. After the aggregate is, if necessary, washed and dried, it is SPS-sintered using a conventional sintering method, at 400 to 800°C, preferably at 450 to 650°C, for example, in the case of $CoSb_3$, so that a thermoelectric converter having a continuous phase of the thermoelectric conversion material is obtained, in which a dispersion phase of scattered ceramic particles is formed.

The structure size(the particle diameter of or the dispersion distance between the insulating materials) can be controlled at the nanoscale by the method for manufacturing of the thermoelectric conversion material of the present invention. That is, by preparing an aggregate wherein the ceramic particles having an average particle diameter of 1 to 100 nm and the thermoelectric conversion material particles are evenly distributed, the structure size of the thermoelectric converter (dispersion distance between the ceramics) becomes smaller than the mean free path of the phonons and preferably larger than the mean free path of a carrier, so that the phonons in the thermoelectric converter are sufficiently scattered and thermal conductivity $\kappa$ can be decreased. Consequently, a thermoelectric converter having a high performance index ZT represented by the formula (1) is obtained. As can be seen above, a thermoelectric converter having a high performance index ZT more than 2, which was difficult to realize in the prior art, can be obtained by the method for manufacturing the thermoelectric converter according to the present invention.

EXAMPLE

1.0 g of cobalt chloride and 2.88 g of antimony chloride were added to and dissolved in 100 mL of ethanol, and 0.2 g of alumina particles having the average particle diameter of 30 nm were added thereto to prepare a dispersion liquid. The pH of the dispersion liquid was 1. The dispersion liquid was dropped into a reducing agent solution wherein 2.0 g of sodium borohydride was dissolved in 100 mL of ethanol. Then, impurities were removed by washing with a mixed solution of ethanol and water, followed by a hydrothermal synthesis for 24 hours at 240°C to produce a thermoelectric conversion material of $CoSb_3$ compound. The TEM image of the composite particles thus obtained is shown in FIG. 3. The composite particles were filled and SPS-sintered at 600°C to obtain the thermoelectric converter of the present invention. The TEM image of the converter is shown in FIG. 4.

In the thermoelectric converter thus obtained, the dispersion phase of alumina having the average diameter of 1 to 100 nm was evenly distributed in the continuous phase of $CoSb_3$ thermoelectric conversion material.

## Claims

1. A method for manufacturing a thermoelectric converter, comprising the steps of:

   preparing an alcohol dispersion liquid comprising a ceramic particle having an average diameter of 1 to 100 nm, and a salt of an element constituting a thermoelectric conversion material; and
   dropping the dispersion liquid into a solution containing a reducing agent to deposit a raw material particle of the thermoelectric conversion material, which is then subject to heating and sintering.

2. The method for manufacturing a thermoelectric converter according to claim 1, wherein the salt of an element constituting the thermoelectric conversion material is selected from the group consisting of cobalt chloride, antimony chloride, bismuth chloride, and tellurium chloride.

3. The method for manufacturing a thermoelectric converter according to claim 1, wherein the thermoelectric conversion material is $CoSb_3$ type or $Bi_2Te_3$ type.

4. The method for manufacturing a thermoelectric converter according to claim 1, wherein the reducing agent is sodium borohydride.

# Fig.1

# Fig. 2

α

σ

κ

FREE PATH OF
THE CARRIER

FREE PATH OF
THE PHONON

STRUCTURE SIZE

## Fig.3

CoSb3

50nm

## Fig.4

Al₂O₃

Al₂O₃

CoSb3

10 nm

## INTERNATIONAL SEARCH REPORT

| | International application No. |
|---|---|
| | PCT/JP2008/060321 |

A.   CLASSIFICATION OF SUBJECT MATTER
*H01L35/34*(2006.01)i, *B22F9/24*(2006.01)i, *C22C1/05*(2006.01)i, *H01L35/16*(2006.01)i, *H01L35/18*(2006.01)i, *B22F3/14*(2006.01)n

According to International Patent Classification (IPC) or to both national classification and IPC

B.   FIELDS SEARCHED

Minimum documentation searched (classification system followed by classification symbols)
H01L35/34, B22F9/24, C22C1/05, H01L35/16, H01L35/18, B22F3/14

Documentation searched other than minimum documentation to the extent that such documents are included in the fields searched
Jitsuyo Shinan Koho        1922-1996   Jitsuyo Shinan Toroku Koho   1996-2008
Kokai Jitsuyo Shinan Koho  1971-2008   Toroku Jitsuyo Shinan Koho   1994-2008

Electronic data base consulted during the international search (name of data base and, where practicable, search terms used)

C.   DOCUMENTS CONSIDERED TO BE RELEVANT

| Category* | Citation of document, with indication, where appropriate, of the relevant passages | Relevant to claim No. |
|---|---|---|
| Y | JP 2005-343782 A  (Capsugel Japan Inc.), 15 December, 2005 (15.12.05), Par. Nos. [0030] to [0033] (Family: none) | 1-4 |
| Y | JP 2002-012427 A  (National Institute of Advanced Industrial Science and Technology), 15 January, 2002 (15.01.02), Par. No. [0013] (Family: none) | 1-4 |
| Y | JP 2007-021670 A  (Dainippon Printing Co., Ltd.), 01 February, 2007 (01.02.07), Par. Nos. [0031] to [0032] (Family: none) | 1-4 |

| ☒ | Further documents are listed in the continuation of Box C. | ☐ | See patent family annex. |
|---|---|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered    to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 28 August, 2008 (28.08.08) | 09 September, 2008 (09.09.08) |

| Name and mailing address of the ISA/ | Authorized officer |
|---|---|
| Japanese Patent Office | |
| Facsimile No. | Telephone No. |

Form PCT/ISA/210 (second sheet) (April 2007)

**INTERNATIONAL SEARCH REPORT**

| International application No. |
|---|
| PCT/JP2008/060321 |

C (Continuation).   DOCUMENTS CONSIDERED TO BE RELEVANT

| Category* | Citation of document, with indication, where appropriate, of the relevant passages | Relevant to claim No. |
|---|---|---|
| Y | WO 2006/062582 A2  (TOYOTA TECHNICAL CENTER USA, INC.), <br> 15 June, 2006 (15.06.06), <br> Full text <br> & US 2006/0118158 A1     & US 2006/0118064 A1 <br> & EP 1820224 A          & EP 1824593 A <br> & CA 2589991 A          & CN 1115553 A <br> & JP 2008-523614 A | 1-4 |
| Y | JP 2000-261047 A  (NGK Insulators, Ltd.), <br> 22 September, 2000 (22.09.00), <br> Claims 1, 5 <br> (Family: none) | 1-4 |
| Y | JP 11-097750 A  (Toshiba Corp.), <br> 09 April, 1999 (09.04.99), <br> Claims 1, 2 <br> (Family: none) | 1-4 |
| P,X | WO 2007/066820 A1  (Toyota Motor Corp.), <br> 14 June, 2007 (14.06.07), <br> Page 12, line 2 to page 14, line 19 <br> (Family: none) | 1-4 |

Form PCT/ISA/210 (continuation of second sheet) (April 2007)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2000261047 A
- JP 3148879 A